# EUROPÄISCHE PATENTANMELDUNG

(11) **EP 3 944 286 A1**
(43) Veröffentlichungstag der Anmeldung: **26.01.2022**
(21) Anmeldenummer: 21184725.6
(22) Anmeldetag: 09.07.2021
(51) Int. Cl.: H01J 37/32, C23C 16/04

(54) **VORRICHTUNG ZUM BESCHICHTEN VON BEHÄLTNISSEN MIT WECHSELEINRICHTUNG UND VERFAHREN ZUM BESCHICHTEN VON BEHÄLTNISSEN**

(30) Priorität: 21.07.2020 DE 102020119167
(71) Anmelder: KRONES AG, 93073 Neutraubling (DE)
(72) Erfinder: Senn, Konrad, 93073 Neutraubling (DE); Eder, Andreas, 93073 Neutraubling (DE); Winzinger, Frank, 93073 Neutraubling (DE); Neubauer, Michael, 93073 Neutraubling (DE); Knott, Josef, 93073 Neutraubling (DE)
(74) Vertreter: Bittner, Bernhard

(57) **Zusammenfassung**

Vorrichtung (1) zum Beschichten von Behältnissen (10) mit einer Vielzahl von Beschichtungsstationen (20) und einer Transporteinrichtung (2), welche diesen Beschichtungsstationen (20) die zu beschichtenden Behältnisse (10) zuführt und die von den Beschichtungsstationen (20) beschichteten Behältnisse (10) von den Beschichtungsstationen abführt, wobei jede dieser Beschichtungsstationen eine erste Elektrode (22) sowie eine zweite Elektrode aufweist, wobei wenigstens eine Elektrode einen in die Behältnisse (10) einführbaren Körper (22) aufweist wobei jede dieser Beschichtungsstationen wenigstens ein wechselbares Formatteil (22) aufweist. Erfindungsgemäß weist die Vorrichtung (1) eine Wechseleinrichtung (4, 50) zum automatischen Wechseln wenigstens eines Formatteils (22) auf.

## Beschreibung

Die vorliegende Erfindung bezieht sich auf eine Vorrichtung zum Beschichten von Behältnissen. Im Stand der Technik ist es bekannt, dass Behältnisse, insbesondere Kunststoffbehältnisse, teilweise an ihren Innenoberflächen beschichtet werden, insbesondere, um ein Diffundieren von Gasen aus dem Behältnis heraus oder in dieses hinein zu vermeiden. Zu diesem Zweck wird teilweise eine Beschichtung vorgenommen bzw. angebracht, wobei eine oder mehrere Elektroden in das Innere des Behältnisses eingeführt werden, um so die Beschichtung an dessen Innenoberfläche zu erreichen.

Ein großes Problem ist hierbei, dass die zum Beschichten verwendeten Elemente, beispielsweise die einzuführenden Elektroden, sehr stark verschmutzen und daher vergleichsweise oft ausgewechselt und/oder gereinigt werden.

Die DE 10 2017 128 550 beschreibt eine Vorrichtung zum Beschichten von Behältern mit wenigstens einem Ventilblock. Dabei weist der Ventilblock einen Vakuumblock mit einer Vertiefung auf, in der Absaugleitungen zur Erzeugung eines Abgasstroms verbunden sind. Weiterhin weist die Vorrichtung einen Verriegelungsrahmen auf, der derart beschaffen ist, dass Vakuumventile in einer Verriegelungsposition unlösbar mit einer Tragplatte verbunden sind und in einer Entriegelungsposition von dieser Tragplatte entfernbar sind.

Auch hier ist jedoch die Entfernung der Ventilpatronen zu Service- und Austauschzwecken aufwendig, da zum Einsetzen der Patronen eine genaue Positionierung in einer Umfangsrichtung einzuhalten ist und aufgrund eines Verschlusses eine Verdrehung vorgenommen werden muss.

Damit wird im Stand der Technik dieser Austausch manuell geführt.

Die Anmelderin erprobt derzeit derartige Maschinen. Es handelt sich hierbei um eine Maschine, die in der Lage ist, Behälter auf der Innenseite zu beschichten. Dabei handelt es sich bevorzugt um Kunststoffbehälter. Die Behälter werden auf der Innenseite mit einer dünnen Barriere-Schicht ausgestattet. Somit wird der Gasaustausch durch die Kunststoffwand (z.B. CO2-Austritt und O2-Eintritt) deutlich reduziert. Bei der Schicht kann es sich beispielsweise um eine extrem dünne Glasschicht handeln.

Zum Erzeugen der Beschichtung wird zuerst die Behandlungskammer incl. Behälter evakuiert. Anschließend werden verschiedene Gase ins Innere der Flasche geleitet. Der Beschichtungsvorgang wird dann durch Erzeugen eines Plasmas im Flascheninneren eingeleitet. Dazu werden zwei Elektroden in den Behälter eingeführt, die mit einer Hochspannung beaufschlagt werden.

Wie oben beschrieben wird der Behälter auf der Innenseite mit einer sehr dünnen Glasschicht versehen. Diese wird durch Abscheiden des Gases auf der Behälterwandung erzeugt. Während des Prozesses können sich auch die Elektroden im Inneren des Behälters befinden. Deshalb bildet sich auch auf diesen im Laufe der Zeit eine immer weiter wachsende Glasschicht. Diese Schicht führt nach einiger Zeit dazu, dass die Erzeugung des Plasmas gestört wird und das Beschichtungsergebnis verschlechtert wird.

Daher muss die Elektrode von Zeit zu Zeit aus der Maschine ausgebaut und von der unerwünschten Schicht befreit werden. Die Elektrode ist daher bevorzugt mit einem Schnellwechselsystem ausgestattet und der Aufbau der kompletten Beschichtungsanlage ist so aufgebaut, dass ein kurzes Stilllegen eines Teils der Anlage möglich ist, ohne die komplette. Anlage anhalten zu müssen.

Der vorliegenden Erfindung liegt daher die Aufgabe zugrunde, für derartige Vorrichtungen Austausch- und/oder Reinigungsprozesse, zumindest teilweise automatisiert, durchzuführen. Daneben liegt der vorliegenden Erfindung die Aufgabe zugrunde, derartige Austausch- und/oder Reinigungstätigkeiten schneller als im Stand der Technik üblich, durchführen zu können. Diese Aufgaben werden erfindungsgemäß durch die Gegenstände der unabhängigen Patentansprüche erreicht. Vorteilhafte Ausführungsformen und Weiterbildungen sind Gegenstand der Unteransprüche.

Eine erfindungsgemäße Vorrichtung zum Beschichten von Behältnissen weist eine Vielzahl von Beschichtungsstationen auf sowie eine Transporteinrichtung, welche diesen Beschichtungsstationen die zu beschichtenden Behältnisse zuführt und die von den Beschichtungsstationen beschichteten Behältnisse von den Beschichtungsstationen abführt. Dabei weist bevorzugt jede dieser Beschichtungsstationen eine erste Elektrode auf sowie eine zweite Elektrode, wobei jede dieser Beschichtungsstationen wenigstens ein wechselbares Formatteil aufweist. Anstelle der oder den Elektroden kann auch ein anderes eine Plasmazündung auslösendes Element vorgesehen sein wie etwa ein ein Magnetfeld erzeugendes Element. Die Anmelderin behält sich vor, auch für eine derartige Anordnung Schutz zu beanspruchen

Erfindungsgemäß weist die Vorrichtung eine Wechseleinrichtung zum wenigstens teilautomatischen und bevorzugt vollautomatischen Wechseln wenigstens dieses Formatteils und/oder eine Reinigungseinrichtung zum automatischen Reinigen wenigstens eines Formatteils auf. Ausgestaltungen dieser Reinigungseinrichtung werden unten genauer erläutert

Bei einer bevorzugten Ausführungsform weist wenigstens eine Elektrode einen in die Behältnisse einführbaren Körper auf (oder ist ein solcher Körper).

Es wird daher im Rahmen der Erfindung vorgeschlagen, dass mittels einer Wechseleinrichtung, die unten genauer beschrieben wird, dieser Wechsel des Formatteils zumindest teilautomatisch und bevorzugt vollautomatisch durchgeführt wird. Zusätzlich oder alternativ ist auch eine Reinigung eines Formatteils möglich. Dabei kann diese Reinigung in einem montierten Zustand des Formatteils erfolgen oder auch in einem demontierten Zustand.

Bei einer weiteren vorteilhaften Ausführungsform weist auch die zweite Elektrode einen in die Behältnisse einführbaren Körper auf. Dabei ist es möglich, dass beide Elektroden in das zu beschichtende Behältnis eingeführt werden. Bei einer weiteren bevorzugten Ausführungsform weist die Vorrichtung eine Druckbeaufschlagungseinrichtung auf, welche das Behältnis und insbesondere auch einen Innenraum des Behältnisses mit einem Unterdruck beaufschlagt.

Bei einer weiteren bevorzugten Ausführungsform weist die Beschichtungsstation eine Kammer auf, innerhalb derer das zu beschichtende Behältnis aufnehmbar ist. Diese Kammer ist dabei bevorzugt abschließbar, insbesondere derart, dass sie mittels eines Dichtmittels luftdicht abschließbar ist.

Dabei ist bevorzugt auch diese Kammer mit einem Unterdruck beaufschlagt. Bei einer bevorzugten Ausführungsform werden sowohl die Kammer als auch das Behältnis mit dem besagten Unterdruck beaufschlagt. Auf diese Weise kann verhindert werden, dass das Behältnis während des Beschichtungsvorgangs implodiert.

Bei einer bevorzugten Ausführungsform weist die Beschichtungsstation wenigstens eine Ventileinrichtung auf, wobei diese Ventileinrichtung insbesondere der Beaufschlagung der Kammer und/oder des Behältnisses mit einem Unterdruck dient. Auch kann eine Ventileinrichtung vorgesehen sein, um die Innenwandung der Behältnisse mit einem Plasma zu beaufschlagen.

Bevorzugt ist eine Vielzahl von Ventilen vorgesehen und diese sind insbesondere an oder in einer Ventileinheit wie insbesondere einem Ventilblock angeordnet.

Bei einer bevorzugten Ausführungsform ist die Wechseleinrichtung dazu geeignet und bestimmt, einen Teil der Beschichtungsstation und dabei bevorzugt die vollständige Beschichtungsstation auszuwechseln.

Bei einer weiteren bevorzugten Ausführungsform transportiert die Transporteinrichtung die Behältnisse entlang eines vorgegebenen Transportpfads. Bevorzugt transportiert die Transporteinrichtung die Behältnisse zumindest teilweise getaktet. Bevorzugt findet der eigentliche Beschichtungsvorgang während eines Stillstandes der Behältnisse in der Transportrichtung statt. So können die Behältnisse der oder den Beschichtungsstationen zugeführt werden, dort während eines Stillstands beschichtet werden und anschließend in einem Beschichteten Zustand weitertransportiert werden, etwa zu einer Befüllungseinrichtung.

Bei einer weiteren bevorzugten Ausführungsform transportiert die Transporteinrichtung die zu beschichtenden Behältnisse vereinzelt. Bevorzugt weist die Transporteinrichtung zu diesem Zweck Halteeinrichtungen auf, die zum Halten der Behältnisse geeignet und bestimmt sind.

Bevorzugt sind die Beschichtungsstationen stationär gegenüber dem Transportpfad der Behältnisse angeordnet.

Bei einer weiteren bevorzugten Ausführungsform ist das wechselbare Formatteil ein in die Behältnisse einführbarer Körper. Insbesondere handelt es sich dabei um einen stangenförmigen oder lanzenförmigen Körper. Dabei kann sich dieser stangenförmige Körper entlang einer geraden Richtung erstrecken, es wäre jedoch auch möglich, dass dieser stangenförmige Körper einen wenigstens. abschnittsweise gekrümmten Verlauf aufweist

Dieser stangen- oder lanzenförmige Körper dient dabei insbesondere als wenigstens eine der beiden Elektroden. Bei einer bevorzugten Ausführungsform ist der das Formatteil oder einführbare Körper mittels einer Anschlusseinrichtung an einem Anschluss angeordnet. Dieser Anschluss ermöglicht dabei bevorzugt einen Fluss eines fließfähigen Mediums in den stangenartigen Körper hinein und/oder aus dem stangenartigen Körper heraus. Bei einer weiteren bevorzugten Ausführungsform kann der stangenartige Körper Öffnungen aufweisen, durch welche ein Medium aus dem stangenartigen Körper austreten kann.

So ist es möglich, dass die Lanzen, bzw. der lanzenförmige Körper für die Beschichtung (bei der es sich insbesondere um eine Plasmabeschichtung handelt) mittels eines Schnellverschlusses (welcher hier die Befestigungseinrichtung ausbildet) an dem Anschluss angeordnet ist.

Bevorzugt handelt es sich bei dem Anschluss um einen Medienzuführungsanschluss und insbesondere einen Gaszuführungsanschluss.

Damit ist bevorzugt die besagte Lanze an den Gaszuführungen angebracht und kann dort mittels einer Wechseleinrichtung, wie beispielsweise mittels eines Roboters oder eines Mitnehmers, automatisch entriegelt und mitgenommen werden. Bevorzugt ist dabei die besagte Lanze bzw. der besagte stangenförmige Körper werkzeugfrei von dem Anschluss lösbar und/oder werkzeugfrei an dem Anschluss befestigbar.

Bei einer besonders bevorzugten Ausführungsform handelt es sich bei dem Anschluss um einen Bajonettanschluss. Bajonettanschlüsse eignen sich in besonderer Weise, da diese auch durch eine automatische Handhabungseinrichtung, wie etwa einem Robotergreifer oder dergleichen, einfach gewechselt werden können.

Zwischen oder an dem Anschluss und dem in die Behältnisse einführbarem Körper oder an diesem Körper kann ein Dichtungselement angeordnet sein, beispielsweise ein Gummiring, um den Anschluss und den Körper zueinander abzudichten. Allgemein kann in dem Verbindungsbereich zwischen einem Formatteil und einer Beschichtungsstation (im folgenden "Station") ein Dichtungselement angeordnet sein.

So ist es beispielsweise möglich, dass ein derartiger Mitnehmer, beispielsweise auf einer Transporteinrichtung, wie etwa auf einem Langstator, beweglich oder sitzend angeordnet ist. Bei dieser Ausführungsform ist die Transporteinrichtung insbesondere als linearmotorische Antriebseinrichtung ausgebildet. Es wäre jedoch auch möglich, dass ein derartiger Mitnehmer beispielsweise an einer Transportkette, wie beispielsweise auch der Behältertransportkette, sitzend angeordnet ist.

Für den Transport der Mitnehmer kann dieselbe Transporteinrichtung, zumindest Teile davon, insbesondere ein Langstator oder Transportkette, verwendet werden, mittels welcher Behältnisse transportiert werden. Für ein Greifen der Formatteile können beispielsweise dieselben Greifer wie für die Behältnisse verwendet werden oder andere Greifer, welche ausschließlich für einen Wechsel dienen.

Ein "Greifen" kann ein aktives Greifen mittels zweier Greifklauen bedeuten oder lediglich durch ein Halten durch einen Magneten.

Auf diese Weise kann eine automatische Entriegelung und/oder Mitnahme des Formatteils erfolgen.

Bei einer weiteren bevorzugten Ausführungsform weist die Vorrichtung zumindest eine Magazineinrichtung zum zumindest vorübergehenden Aufbewahren der Formatteile auf. So kann beispielsweise ein Magazin für Formatteile, wie die oben beschriebenen Lanzen (bzw. stangenförmigen Körper) vorgesehen sein, durch welches nicht benötigte Lanzen, das heißt Lanzeneinrichtungen zumindest vorübergehend gelagert werden.

So ist es möglich, dass die Formatteile, wie beispielsweise die Lanzen, durch eine Transporteinrichtung von den Beschichtungsstationen entnommen werden und in das Magazin verbracht werden. Auch dies kann dabei bevorzugt automatisch erfolgen.

Das Magazin kann eine eigene separate Transporteinrichtung für Formatteile umfassen.

Es wird darauf hingewiesen, dass jedoch auch andere Formatteile gewechselt werden können wie beispielsweise Ventile, Kammern, Düsen oder dergleichen.

Insbesondere ist es möglich, dass ein Formatteil über eine formschlüssige Verbindung mit der Station verbunden ist, was beispielsweise auf den angesprochenen Bajonettverschluss zutrifft.

Alternativ oder zusätzlich ist es möglich, dass ein Formatteil über eine kraftschlüssige Verbindung mit der Station verbunden ist, was beispielsweise über ein im Verbindungsbereich angeordnetes, federkraftbeaufschlagtes Element realisiert werden kann. Z.B. kann das Formatteil über eine Spiralfeder, einen Gummi, einen Magneten oder eine Blattfeder an ein Teil der Station gedrückt oder gezogen werden.

Alternativ oder zusätzlich ist es möglich, dass ein Formatteil über eine reibschlüssige Verbindung mit der Station verbunden ist, was beispielsweise über zwei im Verbindungsbereich angeordnete, leicht zueinander geneigte Oberflächen (eine ist am Formatteil und die andere an der Station) realisiert werden kann, welche sich während des Einführens bzw. Fixierens berühren und so lange aufeinander gleiten, bis eine bestimmte Position oder Kraft erreicht ist.

Bevorzugt ist es auch möglich, dass entsprechende Formatteile von einer Aufbewahrungseinrichtung entnommen und zu den Beschichtungsstationen gefördert werden.

Bei einer weiteren bevorzugten Ausführungsform weist die Vorrichtung eine Reinigungseinrichtung zum Reinigen des Formatteils auf. Dabei kann diese Reinigungseinrichtung in der Magazineinrichtung angeordnet sein. Es wäre jedoch auch möglich, dass diese separat ausgebildet ist.

Dabei ist es möglich, dass diese Reinigungseinrichtung beispielsweise ein Tauchbad oder dergleichen aufweist, in welches die Formatteile eingetaucht werden. Daneben und/oder zusätzlich wäre es auch möglich, dass die Reinigungseinrichtung derart gestaltet ist, dass die Formatteile mit einem Reinigungsmedium beaufschlagt werden. Daneben und/oder zusätzlich ist es auch möglich, dass diese Reinigungseinrichtung mechanische bzw. bewegliche Elemente aufweist, welche dazu dienen, die Formatteile auch durch einen mechanischen Kontakt zu reinigen. So könnten beispielsweise Bürstenelemente zum Reinigen der Formatteile vorgesehen sein.

Bevorzugt ist dabei eine automatisierte Reinigung der Formatteile möglich. Bei einer bevorzugten Ausführungsform kann die Reinigungseinrichtung eine Vielzahl von Trägereinrichtungen aufweisen, an den die Formatteile zur Reinigung gehalten werden können.

Bei einer weiteren bevorzugten Ausführungsform kann die Reinigungseinrichtung eine Ultraschallerzeugungseinrichtung aufweisen, welche zum Reinigen der Formatteile dient. Daneben oder zusätzlich können auch Reinigungseinrichtungen wie ultraviolette Strahlung einsetzende Reinigungseinrichtungen oder dergleichen eingesetzt werden.

Bei einer weiteren bevorzugten Ausführungsform kann die Reinigungseinrichtung mobil ausgeführt sein und die zu reinigenden Formatteile reinigen, während diese Formatteile in den Stationen fixiert sind. Bei dieser Ausgestaltung ist ein Wechsel der Formatteile oder deren Demontage nicht zwingend nötig.

Dabei wäre es möglich, dass die Reinigungseinrichtung zumindest abschnittsweise entlang der Behältertransportstrecke, ggf. mit demselben für den Behältertransport genutzten Antrieb, transportiert wird und Formatteile von mehreren Stationen reinigt.

Eine derartige mobile Reinigungseinrichtung kann beispielsweise mechanische Reinigungselemente, insbesondere Bürsten und/oder Düsen (bevorzugt beide relativbeweglich zur Station über weitere Antriebe) zur Reinigung aufweisen. Die Düsen können zur Versorgung mit Reinigungsmedien (Druckluft, Reinigungsflüssigkeit (z.B. Seifenwasser) und/oder Wasser) über eine Leitung und einen Anschluss mit einer Medienversorgung verbunden sein (z.B. über einen Drehverteiler oder einen mobilen Tank) oder werden (an jeder Station könnte ein kleiner Anschluss für diese Medien vorhanden sein, mit der sich die Reinigungseinrichtung verbindet).

Alternativ kann die Reinigungseinrichtung durch einen Roboter mit fester Basis gebildet sein, welcher beispielsweise einen Arm mit geeigneter Länge umfasst, der zu jeder Station bewegbar ist. An dem Arm können beispielsweise Bürsten und/oder Düsen angeordnet sein.

Die Reinigungseinrichtung bzw. Medienversorgung bzw. das Magazin kann zur Versorgung mit Reinigungsmedium an eine CIP-Anlage angeschlossen sein, mittels welcher andere Teile einer oder der Abfüllanlage gereinigt werden.

Zusätzlich oder alternativ kann können die Formatteile mit der Reinigungseinrichtung sterilisiert werden. Anstatt Reinigungsmedien können in dem Fall Sterilisationsmedien wie Wasserstoffperoxid oder Peressigsäure oder Wasserdampf oder UV-Strahlung von der Reinigungseinrichtung verwendet werden.

Bei einer weiteren bevorzugten Ausführungsform kann die Vorrichtung auch eine Inspektionseinrichtung aufweisen, welche dazu geeignet und bestimmt ist, die Formatteile zu inspizieren, insbesondere dahingehend zu inspizieren, ob diese ordnungsgemäß gereinigt wurden.

Bei einer weiteren vorteilhaften Ausführungsform weist die Vorrichtung eine Reinigungseinrichtung zum Reinigen des Formatteils in einem eingebauten Zustand des Formatteils auf. Bei dieser Ausgestaltung ist keine Demontage bzw. kein Ausbau des Formatteils und/oder der Elektrode erforderlich. Es wäre hier sogar eine Reinigung im laufenden Betrieb der Anlage denkbar.

Bei dieser Ausgestaltung wird vorgeschlagen, dass die Reinigung in einem eingebauten bzw. montierten Zustand des Formatteils, beispielsweise einer Elektrode erfolgt.

Bei einer weiteren vorteilhaften Ausführungsform weist die Reinigungseinrichtung eine Beaufschlagungseinrichtung auf, welche das Formatteil und insbesondere die Elektrode mit einem fließfähigen Medium und insbesondere mit Trockeneis beaufschlagt.

Auf diese Weise können die Formatteile und insbesondere die Elektrode(n) im eingebauten Zustand mittels einer Bestrahlung mit Trockeneis gereinigt werden. Trockeneisstrahlen sind aus dem Stand der Technik bekannt. Dabei werden Pellets aus CO2 mittels Druckluft beschleunigt und auf den zu reinigenden Gegenstand 'geschossen'. Wendet man dieses Vorgehen im vorliegenden Anwendungsfall an, so findet eine Reinigung (und insbesondere eine Entfernung der Glasschicht von der Elektrode) statt. Eine aufwändige manuelle Reinigung entfällt dadurch.

Wenn die Formatteile bzw. Elektroden im eingebauten Zustand gereinigt werden, ist keine aufwendige Demontage erforderlich. Außerdem ist kein zweiter Satz Elektroden notwendig, um während einer Reinigung des ersten Elektrodensatzes außerhalb der Maschine trotzdem weiter produzieren zu können.

Im Idealfall findet die Reinigung während der Übergabezeit der Flaschen statt, sodass der laufende Betrieb komplett. ohne Einschränkungen weiter durchgeführt werden kann. Denkbar ist jedoch auch eine Reinigung bei allgemeinen Stillstandzeiten.

Wenn die Elektroden aus bestimmten Gründen trotzdem zur Reinigung ausgebaut werden sollen/müssen bietet eine Reinigung mittels Trockeneis viele Vorteile, wie z.B.:
eine Schnelle Reinigung und das Verhindern von einer Verschmutzung der Elektroden durch Reinigungsmittel (CO2 verschwindet rückstandslos).

Es wäre jedoch auch möglich, dass dieser Reinigungsvorgang in einer separaten Einrichtung erfolgt. So kann auch eine separate Reinigungsvorrichtung für die Elektroden gebaut werden. Dazu werden die verschmutzten Elektroden aus der Behälterbeschichtungsanlage ausgebaut und in die Reinigungsvorrichtung eingebracht. In dieser werden die 'verschmutzten', also mit Glas beschichteten Elektroden durch einen oder mehrere Strahlen mit Trockeneis gereinigt. Somit werden die Elektroden von ihrer unerwünschten Beschichtung befreit und sind bereit für den nächsten Einsatz.

Bevorzugt weist die Reinigungseinrichtung ein Reservoir für Trockeneis auf. Bevorzugt weist die oben erwähnte Beaufschlagungseinrichtung wenigstens eine und bevorzugt eine Vielzahl von Düsen auf, welche auf das Formatteil und insbesondere die Elektroden das Reinigungsmedium und insbesondere das Trockeneis aufbringen.

Bei einer weiteren bevorzugten Ausführungsform weist die Elektrode und/oder weisen die Elektroden eine spiralförmige und/oder gewendelte Struktur auf. So ist es möglich, dass zwei Elektroden sich jeweils spiralförmige um eine Haupterstreckungsrichtung herum erstrecken. Dabei können diese Elektroden auch gekühlt sein.

Bei einer weiteren bevorzugten Ausführungsform weist die Elektrodenanordnung auch ein Rohr auf, über welches ein gas zugeführt werden kann. Dabei können die Elektroden (bevorzugt spiralförmig um dieses Rohr herum verlaufen.

Alternativ oder zusätzlich kann mit der Inspektionseinrichtung die Dichtigkeit der Verbindung eines Formatteils mit seiner Station überprüft werden. Damit ist bei einer bevorzugten Ausführungsform eine Inspektionseinrichtung vorgesehen, welche zum Überprüfen eines Formatteils bzw. dessen Anordnung an der Vorrichtung dient.

Alternativ oder zusätzlich kann mit der Inspektionseinrichtung überprüft werden, ob ein elektrischer Kontakt zwischen dem Formatteil und der Station nach dem Einsetzen des Formatteils zustande gekommen ist, beispielsweise durch Anlegen einer Spannung zwischen dem Formatteil und der Station.

Es kann nötig sein, die Inspektionseinrichtung beweglich auszuführen bzw. diese in die Wechseleinrichtung zu integrieren. Alternativ kann eine derartige Inspektionsvorrichtung an jeder Station oder an einer Gruppe von Stationen angeordnet sein.

Bei einer weiteren bevorzugten Ausführungsform weisen die Formatteile Markierungen auf, mit denen die Formatteile identifizierbar sind und insbesondere eindeutig identifizierbar sind. So können an den Formatteilen beispielsweise RFID Codes oder QR Codes oder dergleichen angeordnet sein. Alternativ oder zusätzlich können die Formatteile mit einer bzw. der Identifikationsinformation graviert sein.

Bei einer weiteren bevorzugten Ausführungsform weist die Vorrichtung mindestens ein Formatteil zumindest einer bestimmten Sorte (Lanze, Kammer...) mehr auf, als es Stationen gibt. Somit können immer alle Stationen betrieben werden, während ein Formatteil gereinigt wird.

Bei einer weiteren bevorzugten Ausführungsform handelt es sich bei den Formatteilen auch um Ventile der Vorrichtung. So ist es auch möglich, dass Ventile, welche für die Beschichtungsstationen eingesetzt werden, als Formatteile ausgewechselt werden. Auch hierbei können insbesondere Robotereinrichtungen Einsatz finden.

Es wäre jedoch auch möglich, dass vollständige Beschichtungsstationen ausgewechselt werden.

Durch die hier vorgeschlagene Vorgehensweise wäre es auch möglich, dass eine oder mehrere Formatteile einer bestimmten Station gereinigt werden, während weitere Stationen weiterbetrieben werden. Auch wäre es möglich, dass für eine oder mehrere Beschichtungsstationen mehrere Formatteile zur Verfügung stehen, sodass mit Ausnahme der eigentlichen Wechselzeiten ein kontinuierlicher Betrieb sämtlicher Stationen möglich ist. Bevorzugt ist auch während der Wechselzeiten einer bestimmten Station ein Arbeitsbetrieb der weiteren Beschichtungsstationen möglich.

Es wäre weiterhin möglich, dass jeder Beschichtungsstation genau ein bestimmtes Formatteil zugeordnet ist oder auch zwei Formatteile, sodass sichergestellt wird, dass dieselben Formatteile immer an denselben Stationen angeordnet sind und/oder von diesen ausgewechselt werden.

Bei einer weiteren bevorzugten Ausführungsform ist es, wie oben erwähnt, möglich, dass die gesamte, bzw. komplette Beschichtungsstation ausgewechselt wird. In diesem Fall ist es möglich, dass die gesamte Station in der Art einer "plug-and-play-Vorgehensweise" ausgetauscht und gegen eine neue und/oder gewartete Station ausgetauscht werden kann.

Bei einer weiteren bevorzugten Ausführungsform weist die Vorrichtung eine Transporteinrichtung auf, welche Formatteile den Stationen zuführt und/oder welche Formatteile von den Beschichtungsstationen abführt. So können beispielsweise mittels dieser Transporteinrichtung Formatteile, wie die oben erwähnten lanzenartigen Körper, von den Beschichtungsstationen entnommen werden und beispielsweise zu einem Magazin transportiert werden.

Dabei ist es möglich, dass diese Transporteinrichtung eine Robotereinrichtung ist. Eine derartige Robotereinrichtung kann bevorzugt einzelne Formatteile greifen und von den Beschichtungsstationen abnehmen und diese dann zu einer Aufbewahrungseinrichtung, wie beispielsweise der oben genannten Magazineinrichtung verbringen. Dabei kann diese Robotereinrichtung beispielsweise einen schwenk- oder drehbaren Greifarm aufweisen, der auch eine Demontage des jeweiligen Formatteils ermöglicht, beispielsweise ein Lösen des oben erwähnten Bajonettanschlusses.

Insbesondere kann der Lösemechanismus ausschließlich am Formatteil selbst angeordnet sein. So ist es denkbar, dass diese mit der Greifbewegung selbst auslösbar ist und somit beispielsweise kein Gegenhalter oder zweiter Mechanismus nötig ist.

Daneben oder zusätzlich wäre es jedoch auch möglich, dass die Transporteinrichtung eine Fördereinrichtung ist, welche eine Vielzahl von Halteelementen zum Halten der Formatteile aufweist, welche entlang eines vorgegebenen Transportpfads und/oder eines Trägers transportierbar sind.

Dabei kann es sich bei dieser Transporteinrichtung beispielsweise um eine linearmotorische Fördereinrichtung handeln. Diese kann beispielsweise einen linearmotorischen Träger, bzw. eine linearmotorische Bahn, aufweisen, an der mehrere "Shuttles" entlanglaufen können. Diese "Shuttles" sind dabei bevorzugt aktiv ausgestaltet, erlauben also wiederum etwa die Abnahme oder die Hinzufügung von Bauteilen. Dabei sind bevorzugt diese "Shuttles" unabhängig voneinander gegenüber dem Träger bewegbar.

Eine oben beschriebene mobile Reinigungsvorrichtung könnte beispielsweise mittels eines weiteren Shuttles angetrieben werden.

Neben den hier beschriebenen linearmotorischen Fördereinrichtungen wäre es jedoch auch möglich, Fördereinrichtungen, wie beispielsweise Kettenförderer einzusetzen, welche zum Transport der Formatteile dienen.

Dabei wäre es möglich, dass eine Transporteinrichtung sowohl zum Transportieren der Behältnisse dient als auch zum Transportieren der Formatteile. Es wäre jedoch auch möglich, dass zum Transportieren der Behältnisse einerseits und zum Transportieren der Formatteile andererseits unterschiedliche Transporteinrichtungen vorgesehen sind.

Die vorliegende Erfindung ist weiterhin auf ein Verfahren zum Betreiben einer Vorrichtung zum Beschichten von Behältnissen gerichtet, wobei die Vorrichtung eine Vielzahl von Beschichtungsstationen aufweist und eine Transporteinrichtung, welche diesen Beschichtungsstationen die zu beschichtenden Behältnisse zuführt und die von den Beschichtungsstationen beschichteten Behältnisse von den Beschichtungsstationen abführt. Dabei weist jede dieser Beschichtungsstationen eine erste Elektrode sowie bevorzugt eine zweite Elektrode auf, wobei jede dieser Beschichtungsstationen wenigstens ein wechselbares Formatteil aufweist.

Erfindungsgemäß werden mittels einer Wechseleinrichtung die Formatteile wenigstens halbautomatisch gewechselt.

Es wird daher auch verfahrensseitig vorgeschlagen, dass ein Wechsel von Formatteilen wenigstens mittelbar mittels einer Wechseleinrichtung durchgeführt wird. Bevorzugt transportiert dabei die Wechseleinrichtung diese Formatteile wenigstens zeitweise zu einer Beschichtungsstation oder von dieser Beschichtungsstation ab. Bevorzugt transportiert die Wechseleinrichtung die Formatteile zu einem Magazin, bzw. aus einem Magazin zu den Beschichtungsstationen.

Bevorzugt weist wenigstens eine Elektrode einen in die Behältnisse einführbaren Körper auf.

Bei einem bevorzugten Verfahren werden die Formatteile und insbesondere die Elektrode(n) durch Beaufschlagung mit einem fließfähigen Medium und insbesondere mit Trockeneis gereinigt.

Bei einem weiteren bevorzugten Verfahren werden die Formatteile und insbesondere die Elektroden durch Beaufschlagung mit einem fließfähigen Medium und insbesondere mit Trockeneis gereinigt und/oder eine Elektrodenspannung derart geändert, dass Abstoßungseffekte entstehen, welche ein Abplatzen von Verunreinigungen bewirken.

Bei diesem Verfahren wird bevorzugt über die Stromversorgung der Elektrode die Spannung und die Stromstärke so moduliert, dass Abstoßungseffekte entstehen können, durch die die Verunreinigung, insbesondere eine unerwünschte Schicht abplatzt. Bevorzugt findet wenigstens teilweise während oder nach diesem Prozess ein Absaugen und/oder Abführen von Partikeln statt. Auf diese Weise kann eine Verschmutzung der Beschichtungskammer verhindert werden. Bevorzugt erfolgt daher ein relativ gleichzeitiges Absaugen der Partikel erfolgen.

Denkbar wäre auch eine Kombination aus beiden beschriebenen Möglichkeiten, um die Reinigungswirkung noch zu verbessern, d.h. sowohl die Beaufschlagung mit Trockeneise als auch die (Strom- und/oder) Spannungsmodulation.

Insbesondere müssen für ein Lösen des Formatteils nach einem Greifen lediglich maximal drei Bewegungen entlang dreier Achsen durchgeführt werden. Genauso für das Fixieren eines neuen Formatteils.

Bevorzugt ist die entsprechende Vorrichtung in der oben beschriebenen Weise angeordnet. Dabei ist es weiterhin möglich, dass die Transporteinrichtung eine linearmotorische Transporteinrichtung ist oder aber Transporteinrichtungen, wie etwa eine Transportkette, aufweist.

Es sind weiterhin Beschichtungsvorrichtungen bekannt, welche ohne Elektroden den Beschichtungsprozess auslösen können. Beispielsweise kann eine Plasmazündung durch ein Magnetfeld ausgelöst werden. Bei solchen Vorrichtungen könnte auf die genannten Elektroden verzichtet werden.

Weiterhin ist die Erfindung auf eine Vorrichtung zum Beschichten von Behältnissen gerichtet, mit einem Gestell, einer Vielzahl von Beschichtungsstationen und einer Transporteinrichtung, welche diesen Beschichtungsstationen die zu beschichtenden Behältnisse zuführt und die von den Beschichtungsstationen beschichteten Behältnisse von den Beschichtungsstationen abführt, wobei jede dieser Beschichtungsstationen eine erste Elektrode sowie eine zweite Elektrode und eine Kammer aufweist.

Erfindungsgemäß ist vorgesehen, dass zumindest eine Beschichtungsstation lösbar mit dem Gestell verbunden ist und die Vorrichtung eine Wechseleinrichtung zum automatischen Wechseln der wenigstens einen Beschichtungsstation aufweist.

Der Wechsel und eine optionale Reinigung kann mit denselben Mitteln wie bei dem Formatteil durchgeführt werden, die oben bereits beschrieben sind. Die Station kann ebenfalls über gleichartige lösbare Verbindungen, wie oben für die Formatteile (Lanze) beschrieben, mit dem Gestell verbunden sein.

Bevorzugt weist wenigstens eine Elektrode einen in die Behältnisse einführbaren Körper auf.

Neben der Kammer und einer bzw. zwei Elektroden kann auch ein Halter sowie ggf. ein Antrieb für die in den Behälter einbringbare Elektrode mitgewechselt werden.

Während des Wechselns bleiben die zu wechselnden Stationen im zusammengesetzten Zustand.

Die vorliegende Erfindung ist weiterhin auf die Verwendung von Trockeneis zum Reinigen von Formatteilen einer Beschichtungsanlage und insbesondere zum Reinigen von Elektroden einer Beschichtungsanlage und insbesondere einer Beschichtungsanlage zum Beschichten von Kunststoffbehältnissen gerichtet.

Weitere Vorteile und Ausführungsformen ergeben sich aus den beigefügten Zeichnungen.

Darin zeigen:
- Fig. 1: Eine schematische Darstellung einer Beschichtungsstation nach dem Stand der Technik;
- Fig. 2: eine erste Ausgestaltung einer erfindungsgemäßen Vorrichtung zum Beschichten von Behältnissen;
- Fig. 3: eine weitere Ausgestaltung einer erfindungsgemäßen Vorrichtung;
- Fig. 4: eine weitere Ausgestaltung einer erfindungsgemäßen Vorrichtung mit umlaufender Transportkette;
- Fig. 5: eine Darstellung einer erfindungsgemäßen Vorrichtung mit einem Wechselroboter;
- Fig. 6: eine Gesamtdarstellung einer erfindungsgemäßen Anlage zum Herstellen von Behältnissen; und
- Fig. 7: eine beispielhafte Darstellung einer Elektrodenanordnung.

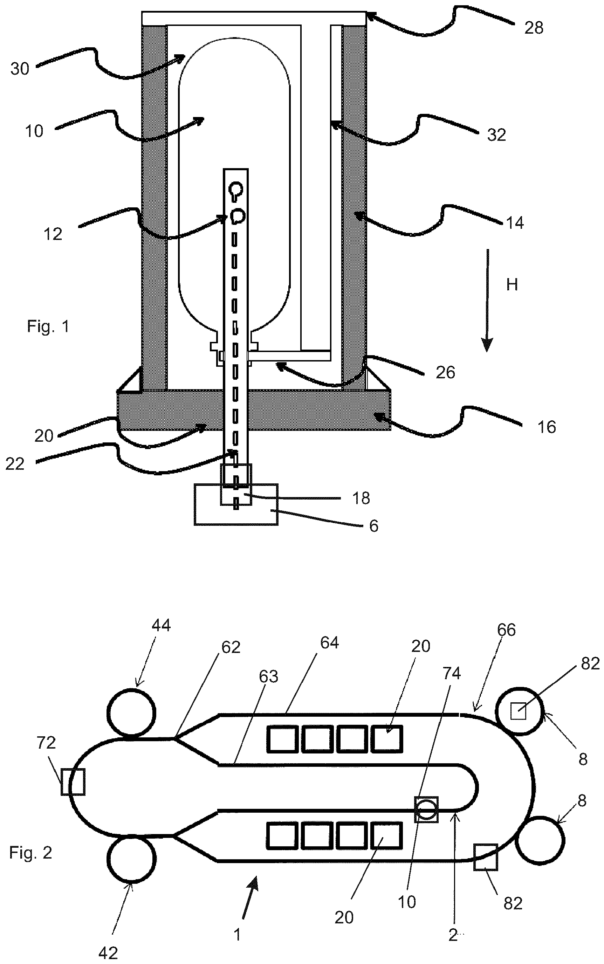

Figur 1 zeigt eine schematische Darstellung einer Beschichtungsstation 20. Dabei bezeichnet das Bezugszeichen 10 das zu beschichtende Behältnis. In dieses Behältnis wird zur Beschichtung eine erste Elektrode 22 in Form einer Lanze eingeführt. Die Bezugszeichen 12 beziehen sich auf Austrittsöffnungen für das Beschichtungsgas, welches zum Beschichten verwendet wird. Eine zweite Elektrode der Beschichtungsstation ist nicht dargestellt. Diese kann jedoch sowohl außerhalb des Behältnisses sein als auch mit in das Behältnis (z.B. parallel zur ersten Elektrode) eingeführt werden.

Bei der hier gezeigten Ausgestaltung ist die Elektrode 22 in der Hubrichtung H stationär angeordnet. Das Behältnis wird über diese Elektrode 22 geschoben und diese auf diese Weise wird die Elektrode 22 in den Innenraum 10 des Behältnisses eingeführt. Diese Elektrode 22 ist hier, wie oben erwähnt als stangenförmiger Körper ausgebildet. Zu diesem Zweck ist eine Greifeinrichtung 26 vorgesehen, welche das Behältnis 10 beispielsweise an seiner Mündung greifen kann. Das Bezugszeichen 32 kennzeichnet ein Trägerelement, an dem die Greifeinrichtung 26 angeordnet ist. Bei der Greifeinrichtung 26 oder bei der Greifeinrichtung inkl. Trägerelement 32 kann es sich auch um ein Formatteil handeln.

Das Bezugszeichen 28 kennzeichnet ein Deckelelement, welches bei Zuführung des Behältnisses den Beschichtungsraum 30 abschließen kann. Dabei wird der Beschichtungsraum derart abgeschlossen, dass innerhalb desselben ein Unterdruck ausgebildet werden kann.

Das Bezugszeichen 16 kennzeichnet einen stationären Träger. Bevorzugt ist damit die Beschichtungsstation stationär angeordnet und die Behältnisse 10 werden der Beschichtungsstation (bevorzugt in einem Taktbetrieb) zugeführt, um beschichtet zu werden.

Nach dem Schließen des Raumes 30 kann dieser Raum 30 evakuiert werden und auch das Behältnis 10 mit einem Unterdruck beaufschlagt werden. Dadurch, dass auch der Aufnahmeraum 30 evakuiert ist, kann es nicht zu einer Implosion des Behältnisses kommen. Anschließend kann der Beschichtungsvorgang starten.

Die Teile 14, 16, 28 können die Kammer bilden.

Insbesondere die Elektrode 22 in Form einer Lanze ist dabei sehr anfällig gegenüber Verschmutzungen und ist daher des Öfteren zu reinigen.

Zu diesem Zweck ist die Elektrode 22 an einer Befestigungseinrichtung 6 lösbar angeordnet. Das Bezugszeichen 18 kennzeichnet Anschlusseinrichtung, mit dem die Elektrode an der Befestigungseinrichtung 6 angeordnet ist. Diese Anschlusseinrichtung 18 kann dabei als Bajonettverschluss ausgeführt sein. Bevorzugt handelt es sich bei der Anschlusseinrichtung jedoch um eine Anschlusseinrichtung 18, welche werkzeugfrei betätigbar ist, um die Elektrode 22 von der Befestigungseinrichtung bzw. dem Anschluss 6 zu lösen. Diese Befestigungseinrichtung 6 ist dabei gleichzeitig ein Anschluss 6 welcher eine Zuführung eines Mediums an die Elektrode 22 ermöglicht.

Damit wird bei der in Fig. 1 gezeigten Ausführungsform die Elektrode von unten eingeführt und das Behältnis ist an einem beweglichen Deckel mittels einer Klammer angeordnet. Die Kammer, in der sowohl die Elektrode, ggfs. eine Hülse als auch der Boden angeordnet sind, ist stationär ausgebildet.

Die Wandung 14 der Behandlungsstation ist stationär mit dem Boden 16 verbunden.

Figur 2 zeigt eine erste Ausgestaltung einer erfindungsgemäßen Vorrichtung. Hier sind acht Beschichtungsstationen 20 vorgesehen, welche jeweils die oben ausgeführte Gestalt aufweisen können und welche insbesondere die Lanze bzw. die stangenförmige Elektrode aufweisen, welche in die Kunststoffbehältnisse einführbar ist.

Das Bezugszeichen 2 kennzeichnet eine Transporteinrichtung für den Normalbetrieb. Dabei ist eine Vielzahl von Halteelementen 74 vorgesehen, welche Behältnisse 10 zu den Beschichtungsstationen 20 transportieren. Diese Halteelemente können dabei beispielsweise Greifer aufweisen. Die Greifer können die Behältnisse insbesondere im Neckhandling transportieren (d.h. insbesondere unterhalb deren Tragringen greifen).

Das Bezugszeichen 42 kennzeichnet eine Einlauftransporteinrichtung, wie einen Einlaufstern, welcher die Behältnisse der Anlage zuführt und das Bezugszeichen 44 kennzeichnet einen Auslassstern, welcher die Behältnisse von der Vorrichtung abführt.

Das Bezugszeichen 66 kennzeichnet eine zweite Transporteinrichtung, welche hier für den Wechselbetrieb der Formatteile dient. Dabei kann diese Transporteinrichtung 66 die zu wechselnden Formatteile beispielsweise von den Beschichtungsstationen 20 zu einer Magazineinrichtung 8 transportieren.

Sowohl die Transporteinrichtung 66 als auch die Transporteinrichtung 2 sind hier als linearmotorische Antriebe ausgestaltet. Das Bezugszeichen 62 kennzeichnet eine Weicheneinrichtung, an der gewählt wird, ob ein Transportelement 72 zum Wechseln der Formatteile den Beschichtungsstationen zugeführt wird oder ob im Arbeitsbetrieb das Transportelement die einzelnen Behältnisse zu den Beschichtungsstationen fördert. Diese beiden Transporteinrichtungen 2 und 66 haben bei der in Fig. 2 gezeigten Ausführungsform ein gemeinsames Wegsegment, an dem sowohl die Transportelemente 72 als auch die Transportelemente 74 transportiert werden.

Bei der hier gezeigten Ausgestaltung sind die Transportzweige 63 und 64 so angeordnet, dass die einzelnen Beschichtungsstationen 20 zwischen diesen angeordnet sind.

Das Bezugszeichen 82 kennzeichnet einen "Mover" bzw. ein "Shuttle", welches zum Auswechseln der Formatteile dient.

Das Magazin 8 kann ein oder zwei angedeutete Karussell(e) umfassen, wobei zumindest eines durch eine Drehbewegung einen leeren Aufnahmeplatz für ein Formatteil oder eine Station in Richtung der Transportstrecke anbieten kann. Durch taktweises oder kontinuierliches Drehen können so nach und nach entnommene Stationen oder Formatteile aufgenommen werden (nicht gezeigt). Entsprechend können im selben Karussell oder wie dargestellt in einem weiteren andere Formatteile abgegeben werden.

Die Aufnahmeplätze können innerhalb des Magazins höhenbeweglich angeordnet sein, so dass beispielsweise ein Eintauchen (in die Bildebene) in ein Tauchbad zur Reinigung durchgeführt werden kann. Das Tauchbad kann entsprechend über einen gewissen Winkelbereich abseits der Übergabepunkte für die Formatteile angeordnet sein, hier also beispielsweise rechts des Magazins / Karussells 8.

Was hier für Langstator-Linearmotor-Transporteure beschrieben wurde ist alternativ über Transportketten und entsprechende Antriebe möglich. Dies gilt im Wesentlichen auch für die folgenden Figuren.

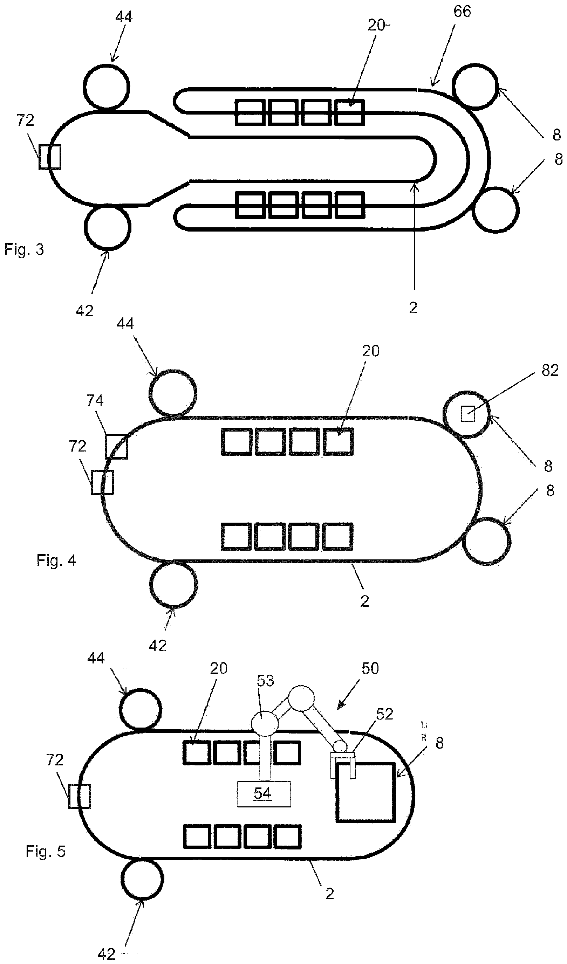

Figur 3 zeigt eine weitere Ausgestaltung, bei der zum Transport sowohl der Behältnisse als auch der Formatteile linearmotorische Antriebe vorgesehen sind. Im Gegensatz zu der in Figur 2 gezeigten Darstellung sind hier zwei separate Transporteinrichtungen vorgesehen. Daneben sind auch hier wieder die beiden Magazineinrichtungen 8 vorgesehen. Das Bezugszeichen 66 kennzeichnet wieder die Transporteinrichtung für den Transport der Formatteile und das Bezugszeichen 2 die Transporteinrichtung für den Transport der Behältnisse.

Figur 4 zeigt eine weitere Ausgestaltung einer erfindungsgemäßen Vorrichtung. Bei dieser Ausgestaltung ist eine Transporteinrichtung 2 vorgesehen, welche sowohl für Halteeinrichtungen 72 für die Behältnisse als auch für Halteeinrichtungen 74 für die Formatteile dient. Dabei können die Formatteile in der gleichen Weise ausgestaltet sein. In einem Arbeitsbetrieb dienen die Halteeinrichtungen dazu, Behältnisse zu den Beschichtungsstationen 20 zu transportieren und in einem Montagebetrieb dienen die Halteeinrichtungen 74 zum Transport der jeweiligen Formatteile. Dabei können die Halteeinrichtungen 72 und 74 gleichartig aufgebaut sein oder auch verschiedenartig.

Die Transporteinrichtung 72 kann dabei als Kettenförderer ausgestaltet sein, also insbesondere eine Transportkette mit Halteeinrichtungen.

Das Bezugszeichen 42 kennzeichnet auch hier einen Zulaufstern und das Bezugszeichen 44 einen Ablaufstern.

Figur 5 zeigt eine weitere Ausgestaltung einer erfindungsgemäßen Vorrichtung. Bei dieser Ausgestaltung ist eine Transporteinrichtung und/oder Wechseleinrichtung in Form einer Robotereinrichtung 50 vorgesehen.

Diese weist hier einen stationären Träger auf, an dem ein mehrgliedriger Roboterarm angeordnet ist, wobei sich das Bezugszeichen 53 auf eine Gelenkeinrichtung bezieht und das Bezugszeichen 52 auf eine Greifeinrichtung, welche zum Greifen der Formatteile, beispielsweise der Lanzen dient. In diesem Fall kann die Robotereinrichtung jeweils von den einzelnen Beschichtungsstationen 20 die Formatteile greifen und in der Magazineinrichtung 8 ablegen.

In diesem Fall ist es möglich, dass der Roboterarm die Formatteile direkt in ein Tauchbad zu deren Reinigung legt. Alternativ kann sich auch das Magazin nach und nach mit Reinigungsflüssigkeit füllen, wenn alle vorgesehenen Formatteile eingelagert wurden. Alternativ kann eine Reinigung durch rotierende Bürsten innerhalb des Magazins durchgeführt werden.

Alternativ kann ein Portalrobotersystem verwendet werden (nicht gezeigt).

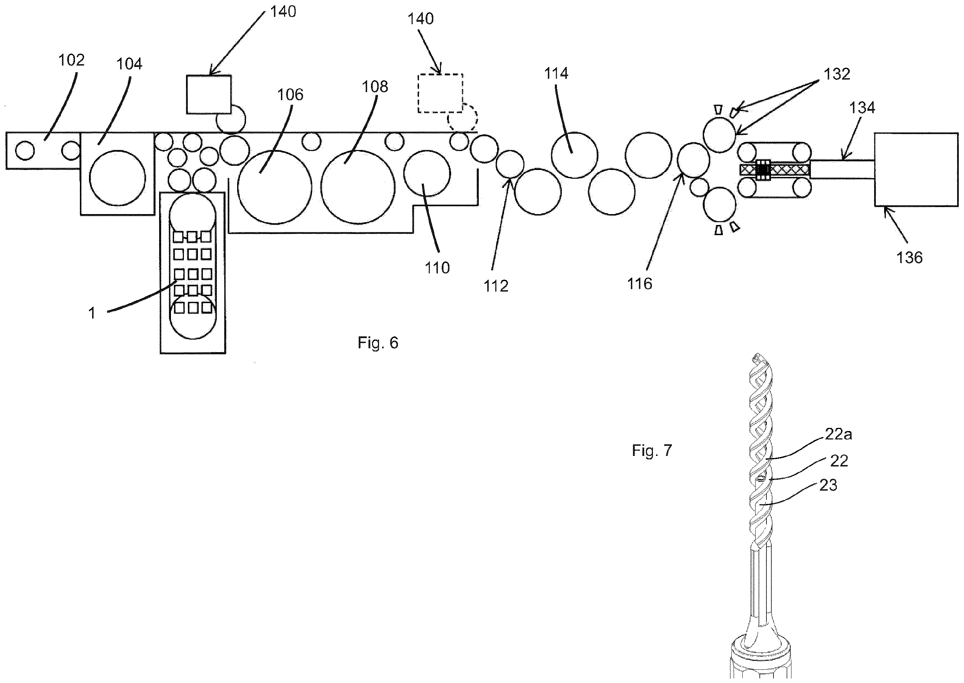

Figur 6 zeigt eine Gesamtdarstellung einer Anlage zum Herstellen von Behältnissen. Dabei ist ein Ofen 102 vorgesehen, der zum Erwärmen von Kunststoffvorformlingen dient. An diesen Ofen 102 schließt sich eine Blasformmaschine 104 an, welche die erwärmten Kunststoffvorformlinge zu Kunststoffbehältnissen und insbesondere Kunststoffflaschen umformt.

Das Bezugszeichen 1 kennzeichnet die hier beschriebene Beschichtungsvorrichtung. Bei der in Figur 6 gezeigten Ausführungsform ist eine Inspektionseinrichtung 140 vorgesehen. In einer alternativen Anlage könnte diese Inspektionsvorrichtung 140 auch an der durch das gestrichelte Rechteck gezeichnete Position angeordnet sein. Daneben könnte die Inspektionseinrichtung 140 auch als Inspektionsstern beispielsweise im Bereich der Beschichtungseinrichtung 1 angeordnet sein.

Das Bezugszeichen 106 kennzeichnet eine Reinigungseinrichtung, wie etwa einen sogenannten Rinser, der beispielsweise zum Ausblasen der hergestellten Behältnisse dient.

Das Bezugszeichen 108 kennzeichnet eine Fülleinrichtung, welche die Behältnisse mit einem Produkt, etwa einem Getränk, befüllt. An diese Fülleinrichtung schließt sich eine Verschließereinrichtung 110 an.

Das Bezugszeichen 112 kennzeichnet eine Trocknungseinrichtung, welche die Behältnisse insbesondere an deren Außenwand trocknet. Das Bezugszeichen 114 kennzeichnet eine Etikettiereinrichtung, welche zum Etikettieren der Behältnisse dient.

Das Bezugszeichen 116 kennzeichnet eine Verteileinrichtung, welche zum Verteilen der einzelnen Behältnisse dient.

Weiterhin kann eine Einpackvorrichtung vorgesehen sein sowie eine Ausrichteeinrichtung, welche beispielsweise mehrere Behältnisse zueinander ausrichtet. Das Bezugszeichen 134 kennzeichnet eine Anordnung, mit der an Gebinde von Behältnissen ein Griff angeordnet werden kann und das Bezugszeichen 136 schließlich eine Palettiereinrichtung.

Anstatt einer Einpackvorrichtung kann zur Gebindeherstellung eine Vorrichtung zum direkten Verkleben von Behältnissen untereinander vorgesehen sein.

Fig. 7 zeigt eine beispielhafte Elektrodenanordnung. Dabei sind hier zwei Elektroden 22, 22a vorgesehen, die sich bezüglich einer Längsrichtung spiralförmig erstrecken. Zwischen diesen Elektroden ist ein Rohr 23 vorgesehen welches während des Beschichtungsvorganges ein Gas zuführt. Diese beiden Elektroden können weiterhin auf gekühlt sein, etwa in dem sie von einem Kühlmedium durchflossen werden.

Weiterhin ist es auch möglich, die Elektroden durch Beaufschlagung mit Trockeneis zu reinigen. Durch die Verwendung von Trockeneis kann hier zusätzlich zu dem Reinigungseffekt auch ein Kühleffekt bewirkt werden.

Die Anmelderin behält sich vor, sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

## Patentansprüche

1. Vorrichtung (1) zum Beschichten von Behältnissen (10) mit einer Vielzahl von Beschichtungsstationen (20) und einer Transporteinrichtung (2), welche diesen Beschichtungsstationen (20) die zu beschichtenden Behältnisse (10) zuführt und die von den Beschichtungsstationen (20) beschichteten Behältnisse (10) von den Beschichtungsstationen abführt, wobei jede dieser Beschichtungsstationen eine erste Elektrode (22) sowie eine zweite Elektrode aufweist, wobei jede dieser Beschichtungsstationen wenigstens ein wechselbares Formatteil (22) aufweist,
**dadurch gekennzeichnet, dass**
die Vorrichtung (1) eine Wechseleinrichtung und/oder Reinigungseinrichtung (4, 50) zum automatischen Wechseln und/oder Reinigen wenigstens eines Formatteils (22) aufweist.

2. Vorrichtung (1) nach Anspruch 1,
**dadurch gekennzeichnet, dass**
wenigstens eine Elektrode einen in die Behältnisse einführbaren Körper (22) aufweist und bevorzugt auch die zweite Elektrode einen in die Behältnisse (10) einführbaren Körper (22) aufweist.

3. Vorrichtung (1) nach wenigstens einem der vorangegangenen Ansprüche,
**dadurch gekennzeichnet, dass**
das wechselbare Formatteil (22) ein in die Behältnisse (10) einführbarer Körper (22) ist.

4. Vorrichtung (1) nach wenigstens einem der vorangegangenen Ansprüche 2 - 3,
**dadurch gekennzeichnet, dass**
das Formatteil (22) oder der einführbare Körper (22) mittels einer Anschlusseinrichtung an einem Anschluss angeordnet ist.

5. Vorrichtung (1) nach dem vorangegangenen Anspruch,
**dadurch gekennzeichnet, dass**
der Anschluss ein Gaszuführanschluss ist.

6. Vorrichtung (1) nach wenigstens einem der vorangegangenen Ansprüche 4 - 5,
**dadurch gekennzeichnet, dass**
der Anschluss einen Bajonettverschluss aufweist.

7. Vorrichtung (1) nach wenigstens einem der vorangegangenen Ansprüche,
**dadurch gekennzeichnet, dass**
die Vorrichtung (1) zumindest eine Magazineinrichtung (8) zum zumindest vorrübergehenden Aufbewahren der Formatteile (22) aufweist.

8. Vorrichtung (1) nach wenigstens einem der vorangegangenen Ansprüche,
**dadurch gekennzeichnet, dass**
die Vorrichtung eine Reinigungseinrichtung (82) zum Reinigen des Formatteils aufweist und/oder die Vorrichtung eine Reinigungseinrichtung (82) Reinigen des Formatteils in einem eingebauten Zustand des Formatteils aufweist.

9. Vorrichtung (1) nach wenigstens einem der vorangegangenen Ansprüche,
**dadurch gekennzeichnet, dass**
die Reinigungseinrichtung eine Beaufschlagungseinrichtung aufweist, welche das Formatteil und insbesondere die Elektrode mit einem fließfähigen Medium und insbesondere mit Trockeneis beaufschlagt.

10. Vorrichtung (1) nach wenigstens einem der vorangegangenen Ansprüche 2 - 3,
**dadurch gekennzeichnet, dass**
die Vorrichtung eine Transporteinrichtung (66) aufweist, welche Formatteile den Beschichtungsstationen (20) zuführt und/oder Formatteile von den Beschichtungsstationen (20) abführt.

11. Vorrichtung nach dem vorangegangenen Anspruch,
**dadurch gekennzeichnet, dass**
die Wechseleinrichtung (50) und/oder die Transporteinrichtung eine Robotereinrichtung (4) ist.

12. Vorrichtung (1) nach Anspruch 10,
**dadurch gekennzeichnet, dass**
die Transporteinrichtung (66) eine Fördereinrichtung ist, welche eine Vielzahl von Halteelementen (72) zum Halten der Formatteile aufweisen, welche entlang eines vorgegebenen Transportpfads transportierbar sind.

13. Vorrichtung (1) zum Beschichten von Behältnissen (10) mit einem Gestell, einer Vielzahl von Beschichtungsstationen (20) und einer Transporteinrichtung (2), welche diesen Beschichtungsstationen (20) die zu beschichtenden Behältnisse (10) zuführt und die von den Beschichtungsstationen (20) beschichteten Behältnisse (10) von den Beschichtungsstationen (20) abführt, wobei jede dieser Beschichtungsstationen (20) eine erste Elektrode (22) sowie eine zweite Elektrode und eine Kammer aufweist,
**dadurch gekennzeichnet, dass**
zumindest eine Beschichtungsstation lösbar mit dem Gestell verbunden ist und die Vorrichtung (1) eine Wechseleinrichtung zum automatischen Wechseln der wenigstens einen Beschichtungsstation (20) aufweist.

14. Verfahren zum Betreiben einer Vorrichtung (1) zum Beschichten von Behältnissen wobei die Vorrichtung (10) eine Vielzahl von Beschichtungsstationen (20) aufweist und eine Transporteinrichtung (2), welche diesen Beschichtungsstationen (20) die zu beschichtenden Behältnisse (10) zuführt und die von den Beschichtungsstationen (20) beschichteten Behältnisse (10) von den Beschichtungsstationen abführt, wobei jede dieser Beschichtungsstationen (20) eine erste Elektrode (22) sowie eine zweite Elektrode aufweist wobei jede dieser Beschichtungsstationen (20) wenigstens ein wechselbares Formatteil (22) aufweist,
**dadurch gekennzeichnet, dass**
mittels einer Wechseleinrichtung und/oder Reinigungseinrichtung (4, 50) die Formatteile wenigstens halbautomatisch gewechselt und/oder gereinigt werden.

15. Verfahren nach Anspruch 13 und/oder 14,
**dadurch gekennzeichnet, dass**
die Formatteile durch Beaufschlagung mit einem fließfähigen Medium und insbesondere mit Trockeneis gereinigt werden und/oder eine Elektrodenspannung derart geändert wird, dass Abstoßungseffekte entstehen, welche ein Abplatzen von Verunreinigungen bewirkt.
